# EUROPEAN PATENT APPLICATION

(11) **EP 1 519 643 A2**
(43) Date of publication of application: **30.03.2005**
(21) Application number: 04255801.5
(22) Date of filing: 23.09.2004
(51) Int. Cl.: H05K 7/10

(54) **Integrated circuit socket contact**

(30) Priority: 29.09.2003 JP 2003337857
(71) Applicant: Tyco Electronics AMP K.K., Kawasaki-shi, Kanagawa-ken 213-8535 (JP)
(72) Inventor: Hashimoto, Shinichi, Tyco Electronics AMP K.K., Kawasaki-shi, Kanagawa-ken 213-8535 (JP)
(74) Representative: Johnstone, Douglas Ian

(57) **Abstract**

The present invention provides an IC socket contact in which the elasticity of a contact arm section, the stability within a housing and the flexibility of a soldered tail section are ensured with minimized inductance. An IC socket contact has a contact arm section that comes into contact with a contact point of an IC package, a fixed section that is fixed to a housing in which the IC package is placed, and a soldered tail section that is soldered to a substrate on which the housing is placed. The contact arm section and the soldered tail section are continuous in a vertical direction. The fixed section is bent back 180° to the back side from a side wall of an intermediate section between the contact arm section and the soldered tail section and extends in a vertical direction.

## Description

### BACKGROUND OF THE INVENTION

### Field of the Invention

The present invention relates to an IC socket contact that has a contact arm section that comes into contact with a contact point of an IC package, a fixed section that is fixed to a housing in which the IC package is to be placed, and a soldered tail section that is soldered to a substrate on which this housing is to be placed.

### Description of the Related Art

There has hitherto been known an IC socket contact that is a metal piece that is inserted into a housing space provided in an insulating housing, which detachably holds an IC package and is disposed beforehand on a circuit substrate, and electrically connects the IC package and the circuit substrate (see Japanese Patent Laid-Open No. 2000-113952, U.S. Patent No. 6132222, and Japanese Patent Laid-Open No. 2002-25730, for example).

Such an IC socket contact is constituted by a contact arm section that includes a contact part with a contact point of an IC package, a fixed section that is a part fixed to a housing in which the IC package is to be placed, and a soldered tail section that includes a part called a paddle that is soldered to a substrate on which this housing is to be placed. The fixed section has a shape wider than the contact arm and the soldered tail section, and this IC socket contact is inserted into a housing space provided in an insulating housing and is fixed when the fixed section abuts against an inner wall of the housing space (hereinafter, this housing space is referred to as a "contact mounting section").

In the contacts for IC socket proposed in the above-described patent documents, in providing electrical connection to an IC package, contact is obtained between a contact point provided at the leading end of the contact arm and a contact point provided in the IC package and the contact between these contact points is made positive by imparting flexibility to this contact arm and ensuring contact pressure between these contact points.

On the other hand, the electrical connection of these contacts for IC socket to a circuit substrate is obtained by soldering a paddle provided at the leading end of the soldered tail section of the contacts for IC socket and a paddle provided on the circuit substrate, and furthermore, by imparting flexibility to this soldered tail section, the occurrence of solder cracks due to a difference in the coefficient of expansion between the housing and the circuit substrate is prevented.

In the IC socket contact disclosed in the above Japanese Patent Laid-Open No. 2000-113952, however, the flexibility of the contact arm section is obtained by causing this part to meander and, therefore, inductance is large, posing the problem that it is impossible to cope with an increase in the speed of signal transmission from the IC package to the circuit substrate.

In the IC socket contact proposed in the above U.S. Patent No. 6132222, the flexibility of the soldered tail section is improved by reducing the area of the contact part of the contact mounting section with the fixed section and making part of the fixed section free. However, the controllability of the position of the contact within the housing decreases accordingly.

In the IC socket contact proposed in the above Japanese Patent Laid-Open No. 2002-25730, a metal plate has a two-forked end, one arm of which is bent back 180° to the end opposite to the two-forked end to be used as a contact arm section, whereas the other arm of which is used as a soldered tail section. In this case, inductance is large because the portion from the contact arm section to the solder tail section is not linear, posing the problem that it is impossible to cope with an increase in the speed of signal transmission from the IC package to the circuit substrate.

In view of the above-described circumstances, the present invention has as its object the provision of an IC socket contact in which the position controllability within the housing and the flexibility of the contact arm section and the soldered tail section are ensured with minimized inductance.

### SUMMARY OF THE INVENTION

An IC socket contact according to the invention to achieve the above-described object is an IC socket contact that has a contact arm section that comes into contact with a contact point of an IC package, a fixed section that is fixed to a housing in which the IC package is placed, and a soldered tail section that is soldered to a substrate on which the housing is placed,
in which the contact arm section and the soldered tail section are continuous in a vertical direction and
the fixed section is bent back 180° to the back side from a side wall of an intermediate section of the contact arm section and the soldered tail section and extends in a vertical direction.

In an IC socket contact according to the invention, the portion from the contact arm section to the soldered tail section is continuous, that is, the signal path is continuous. For this reason, inductance can be minimized. Furthermore, the fixed section of an IC socket contact according to the invention is a part which is bent back 180° to the back side from a side wall of an intermediate section between the contact arm section and the soldered tail section and is formed substantially independently of the contact arm section and the soldered tail section. Thus, regardless of the contact arm section and the soldered tail section it is possible for the fixed section to have a size (height) adapted to the housing. For this reason, according to an IC socket contact of the invention, it is possible to stabilize the position of the IC socket contact mounted on the housing while ensuring the flexibility of the contact arm section and the soldered tail section with respect to the fixed section.

It is preferred that the soldered tail section have a bent part that is bent approximately 90° to the front side from a side wall of an end of the soldered tail.

This enables the flexibility of the soldered tail section to be further increased and, therefore, the occurrence of solder cracks can be more prevented.

According to an IC socket contact of the invention, it is possible to ensure the elasticity of the contact arm section, the stability of the contact arm section in the housing and the flexibility of the soldered tail section while minimizing inductance.

### BRIEF DESCRIPTION OF THE DRAWINGS

Fig. 1 is a drawing that shows a contact of a first embodiment of the invention; and
Fig. 2 is a drawing that shows a contact of a second embodiment of the invention.

### DETAILED DESCRIPTION OF THE INVENTION

Now, a first embodiment of an IC socket contact according to the invention will be described below.

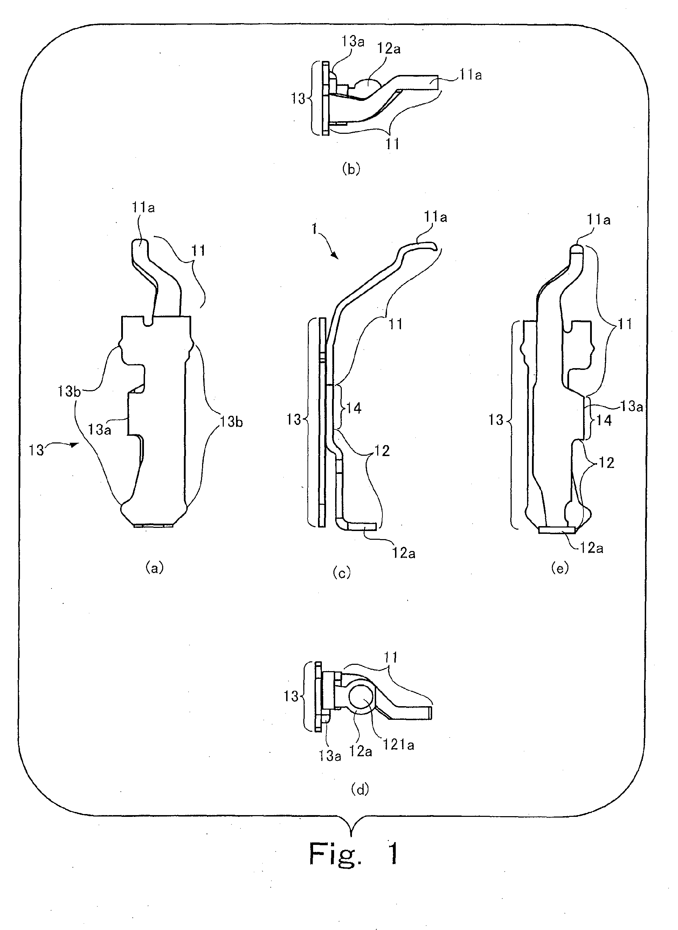

Fig. 1 is a drawing that shows a contact of this embodiment.

A back view of a contact 1 is shown in Part (a) of Fig. 1, a top view thereof in Part (b) , a right side view thereof in Part (c), a bottom view thereof in Part (d), and a front view thereof in Part (e).

The contact 1 shown in Fig. 1 is a metal piece that is inserted into a contact mounting section provided in an insulating housing, which detachably holds an IC package and is disposed beforehand on a circuit substrate, and electrically connects the IC package and the circuit substrate.

As shown in Part (c) of Fig. 1, the contact 1 is constituted by a contact arm section 11 that includes a contact point 11a that comes into contact with an IC package, which is not shown, a soldered tail section 12 that has a paddle 12a that is bonded with a solder to a circuit substrate, which is not shown, an intermediate section 14 that is sandwiched between the contact arm section 11 and the soldered tail section 12, and a fixed section 13 that is a part bent back 180° to the back side from a side wall 13a (see Part (a) of Fig. 1) of this intermediate section 14 and extends in a vertical direction. Incidentally, Part (d) of Fig. 1 shows a semispherical concavity 121a provided in the paddled 12a, which is a solder pool to be used in the bonding to the circuit substrate. This intermediate section 14 corresponds to the intermediate section between the contact arm section and the soldered tail section according to the invention.

The fixed section 13 shown in Part (a) of Fig. 1 has, at both top and bottom ends thereof, press fit projections 13b and the contact 1 is fixed to the housing when these projections are press fit into the contact mounting section.

The contact arm section 11 and the soldered tail section 12 are connected to the fixed section 13 only by the side wall 13a and, therefore, flexibility is ensured for the contact arm section 11 and the soldered tail section 12 with respect to the fixed section 13.

The contact arm section 11 and the soldered tail section 12 are continuous in a vertical direction, that is, the signal path is continuous and, therefore, it is possible to minimize inductance.

Because the fixed section 13 is a part that is bent back 180° to the back side from the side wall 13a of the intermediate section 14 between the contact arm section 11 and the soldered tail section 12 and is substantially independent of the contact arm section 11 and the soldered tail section 12, it is possible for the fixed section 13 has a size (height) adapted to the housing without being limited by the contact arm section 11 and the soldered tail section 12.

As described above, according to the contact 1 of this embodiment, it is possible to stabilize the position of the contact in the housing while ensuring the flexibility of the contact arm section with minimized inductance and without reducing the flexibility of the soldered tail section.

Next, the second embodiment of an IC socket contact according to the invention will be described.

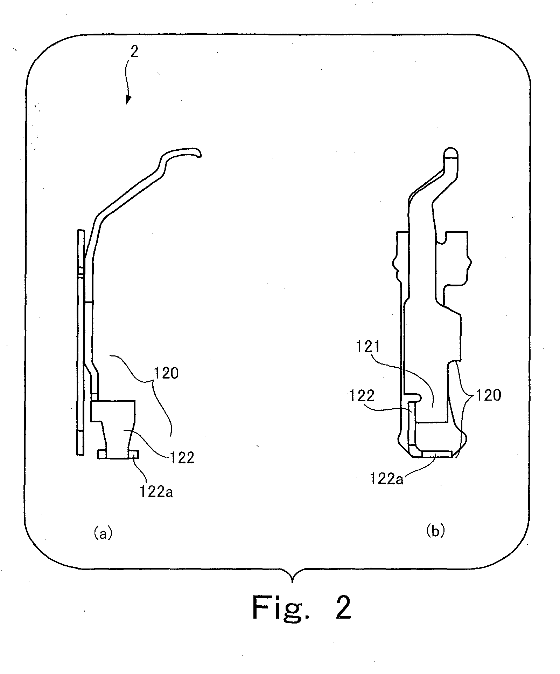

Fig. 2 is a drawing that shows a contact of a second embodiment of the invention.

A right side view of a contact 2 is shown in Part (a) of Fig. 2 and a front view thereof in Part (b). Because the contact 2 of this embodiment differs from the contact 1 of the first embodiment only in a soldered tail section 120, only this soldered tail section 120 will be described below.

The soldered tail section 120 of the contact 2 is constituted by a main section 121 and a bent section 122 that includes a paddle 122a, and the bent section 122 is bent approximately 90° to the front with respect to the main section.

Thus, by changing the direction of the end of the soldered tail section 120 approximately 90°, the range of movement spreads to the right side and the left wide, as well as to the front side and the far side in the drawing of Part (a) of Fig. 2. As a result, it is possible to further increase the flexibility of the soldered tail section and to prevent the occurrence of solder cracks to a greater extent.

## Claims

1. An IC socket contact that has a contact arm section that comes into contact with a contact point of an IC package, a fixed section that is fixed to a housing in which the IC package is placed, and a soldered tail section that is soldered to a substrate on which the housing is placed,
wherein the contact arm section and the soldered tail section are continuous in a vertical direction and
the fixed section is bent back 180° to the back side from a side wall of an intermediate section between the contact arm section and the soldered tail section and extends in a vertical direction.

2. The IC socket contact according to claim 1, wherein the soldered tail section has a bent part that is bent approximately 90° to the front side from a side wall of an end of the soldered tail.
